# EUROPEAN PATENT SPECIFICATION

(11) **EP 2 323 292 B1**
(45) Date of publication and mention of the grant of the patent: **20.07.2016**
(21) Application number: 10191016.4
(22) Date of filing: 12.11.2010
(51) Int. Cl.: H04J 3/06, H04L 7/00, H03H 17/06, H03H 17/02

(54) **Resampler with automatic detecting and adjusting the resampling ratio**
Neuabtaster mit automatischer Erkennung und Einstellung des Neuabtastverhältnisses
Ré-échantillonneur avec détection et réglage automatiques du taux de ré-échantillonnage

(30) Priority: 12.11.2009 EP 09175789
(43) Date of publication of application: 18.05.2011
(73) Proprietor: Dialog Semiconductor B.V., 5215 MV 's-Hertogenbosch (NL)
(72) Inventor: Lubberhuizen, Wessel Harm, 7491 LB, Delden (NL)
(74) Representative: Nederlandsch Octrooibureau

(56) References cited:
- WO-A2-01/89137
- US-A1- 2004 062 252
- US-A1- 2005 157 828
- US-A1- 2007 008 196
- US-B1- 6 553 087

## Description

### Field of the invention

The present invention relates to the field of multi-rate digital signal processing, in particular a resampling device and a method of resampling.

### Background of the invention

When an audio stream is transmitted between two subsystems using different audio sampling frequencies, the audio stream needs to be resampled from a sampling frequency at a source subsystem to a sampling frequency at a destination subsystem. A resampling ratio r is defined as r = fₒᵤₜ / fᵢₙ, wherein fᵢₙ is the sampling frequency at the source subsystem and fₒᵤₜ is the sampling frequency at the destination subsystem.

Examples of systems requiring asynchronous resampling:
- A DECT receiver that sends audio data though a USB interface connected to a host PC.
- A DECT transmitter that receives audio data from a USB interface connected to a host PC.
- A DECT base station that sends and receives audio data through a VOIP connection.
- A DECT base station that sends and receives audio data through an ISDN connection.
- etc.

A resampling device can be implemented either digitally or analog. In an analog implementation an audio signal is converted from a source digital domain to an analog domain, and then from the analog domain to a destination digital domain. This implementation requires a digital to analog converter, analog image rejection filters, and an analog to digital converter. This solution is relatively expensive and not flexible, and prone to distortions, for example noise, phase distortion, non-linear distortion, interference.

A digital resampling device generally comprises one or more of the following elements:

### 1. Anti-aliasing filter

When an output sampling frequency is lower than an input sampling frequency, some of the high frequency content of an input audio stream will be mirrored to a lower frequency. This effect is known as aliasing. To prevent this effect, high frequency components must be removed from the input audio stream using an anti-aliasing filter.

### 2. Upsampler

In general distortions will be more prominent when the ratio between higher frequency components in the input audio stream and the input sampling frequency is larger. To mitigate this effect, the input audio stream can be upsampled to a higher intermediate sampling frequency, for instance using polyphase interpolation. The process of upsampling comprises inserting zero-valued samples between original samples to increase the sampling rate The upsampling can be integrated with the anti-aliasing filter.

### 3. Interpolator

The interpolator generates an actual output data stream based on one or more samples, and the zero-valued samples, that are generated by the upsampler. An interpolating function is fitted to one or more consecutive samples, and evaluated an intermediate time value. The result is as if you had just originally sampled your signal at the higher rate. In a DSP (Digital Signal Processing) description, the interpolating process can be seen as an upsampling process followed by filtering. The filtering removes the undesired spectral images due the upsampling process.

There are various implementations for an interpolator function:
1. Zero order hold
   This solution uses an intermediate register that stores a single input sample. The data is written to this intermediate register at a source sample rate, and read from the intermediate register at a destination sample rate. As a result samples may be repeated or omitted, depending on the resampling ratio. This solution is simple to implement, but may result in large distortions.
2. Linear interpolation
   This solution uses two intermediate registers that hold two consecutive input samples. A sample at an intermediate time value formed by linear interpolation of these two input samples, i.e., the output sample is a weighted average of the two input samples. The weights depend on relative timing of the output sample compared to the input sampling times.
3. Piece-wise polynomial interpolation
   This solution is a generalization of the previous two interpolators to higher order polynomials. A interpolation polynomial is fitted to a finite number of consecutive samples, and evaluated at an intermediate time value to generate the output sample. There are various methods for computing the coefficients of the interpolation polynomial. The following interpolation polynomials are generally used:
   - Lagrange
   - Hermite
   - B-spline
   - Osculating

Normally a digital resampling device comprises at least one type of filtering. Examples of filtering are:
1. Low order filtering:
   This type of filtering is to simply drop or repeat samples, one example is the linear interpolation. The low order filtering provides low processing overhead and low delay, but the quality of this filtering is low since the images are not sufficiently suppressed.
2. High order filtering:
   This type of filtering is widely used in upsampling and polynomial interpolation. The high order filtering provides good quality and more processing, but the trade-off is higher delay.

In practice sampling clocks of the input samples and output samples are often derived from separate timing sources (e.g. crystal oscillators). Hence the sampling clocks are asynchronous.

US2004/062252 discloses a resampling system to measure the clock skew between transmitting and receiving devices operating with independent clock sources over a packet network. To provide adaptive playout in an IP telephony device without a sequencing scheme in the packets, the clock skew is measured and recorded. Using a PCM resampler that is implemented with an interpolation filler bank of FIR subfilters, the change in depth of the playout buffer during transmission is analyzed, and this change infers the clock rate associated with the transmission.

### Summary of the invention

The inventor realised that the timing sources can drift over time under the influence of changes in temperature, humidity, pressure, etc. As a result the ratio of the sampling frequencies of the two subsystems will not be constant, which may influence the quality of the audio stream.

It is an object of the present invention to improve the quality of the audio stream transmitted between two subsystems using different audio sampling frequencies. To achieve this object a first aspect of the invention provides a resampling device as claimed in claim 1. By continuous measuring and adjusting the resampling ratio a high quality audio stream can be maintained under different conditions of temperature, humidity, pressure, etc of the two subsystems. Furthermore, this arrangement enables compatibility with different order filtering and different memory systems taking various trade-offs into consideration.

In an embodiment, in order to provide an optimal trade-off between quality, processing load and memory requirements for a wide range of applications, the user can predefine and choose the values of one or more parameters.
In a further embodiment of the resampling device said adjuster is arranged to detect and adjust the resampling ratio by taking into account the used spaces of said input buffer and the unused spaces of said output buffer. It appears that the number of used spaces of respectively the input buffer and the output buffer provide a good estimate for deviations in the resampling ratio.
In a further embodiment of the resampling device said adjuster is connected to the input buffer, the output buffer, the interpolator, and in an embodiment a memory component. In this arrangement the ratio adjuster may receive parameters from the input and output buffer and store those parameters, other predefined parameters and output samples in the memory component.

In a further embodiment of the resampling device the adjuster comprises a ratio adjuster arranged to automatically and continuously adjust the resampling ratio in dependency of parameters received from said input buffer and output buffer, and further comprises a phase updater, connected to the ratio adjuster, and arranged to continuously and automatically update a phase value of the output data in dependency of parameters received from said ratio adjuster. The phase updater receives the adjusted sample ratio and may provide an updated phase value to the polynomial updater. In a further embodiment of the resampling device said input buffer is arranged to temporally store a plurality of incoming input data samples and to provide a parameter input buffer level indicating used spaces of said input buffer.

In a further embodiment of the resampling device said output buffer is arranged to temporally store a plurality of output samples and to provide a parameter output buffer level indicating the used spaces of said output buffer.

In a further embodiment of the resampling device said adjuster is connected to a memory component arranged to store a plurality of parameters. In a still further embodiment of the resampling device said ratio adjuster is arranged to automatically and continuously adjust said resampling ratio in dependency of the parameter input buffer level and the parameter output buffer level. In a still further embodiment of the resampling device said phase updater is connected to the polynomial evaluator and the memory component, wherein the phase updater is arranged to automatically and continuously update the phase value of the output data in dependency of the resampling ratio: 1) For each output data sample that is generated, the phase is increased by adding a value that is equal to the denominator of said resampling ratio divided by the upsampling factor; 2) For each pre interpolated data sample that is generated, the phase is decreased by subtracting a value that is equal to the numerator of said resampling ratio divided by the upsampling factor. In a still further embodiment of the resampling device wherein the output buffer is connected to the interpolator, and wherein said output buffer is arranged to continuously receive output sample data from said interpolator and store output samples data.

In a still further embodiment of the resampling device said polynomial evaluator is arranged to continuously receive the updated phase value from said phase updater. In a still further embodiment of the resampling device, the device comprises a user interface platform arranged to configure a size of the input buffer and the output buffer.

In a still further embodiment of the resampling device the ratio adjustor is arranged to automatically and continuously adjust the resampling ratio in accordance with:
(unused spaces in output buffer) - (resampling ratio)* (used spaces in input buffer). A further aspect of the invention provides a method as claimed in claim 10 and a computer program as claimed in claim 11.

### Brief description of the drawings

The invention will be explained in detail with reference to some drawings that are only intended to show embodiments of the invention and not to limit the scope. The scope of the invention is defined in the annexed claims and by its technical equivalents. The drawings show:
Figure 1 shows general setup of a computer arrangement suitable to perform the method of the invention.
Figure 2 shows a data flow diagram of whole system.
Figure 3 shows steps of a processing method according to an embodiment.
Figure 4 shows sub-steps of an embodiment of a processing method.
Figure 5 shows sub-steps of an embodiment of a processing method.
Figure 6 shows a Data Flow Diagram of ratio adjuster.
Figure 7 shows a Data Flow Diagram of phase updator.

### Detailed description of embodiments

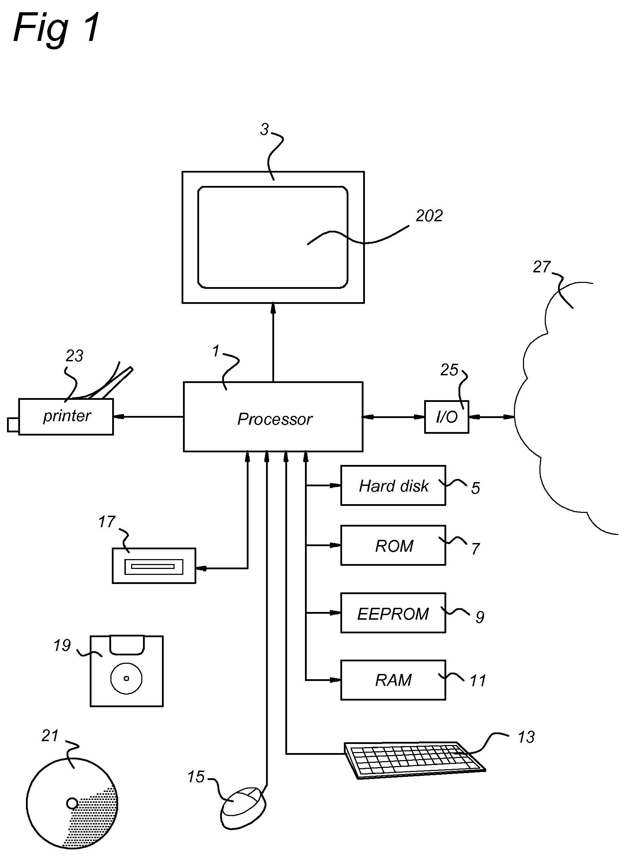

In figure 1, an overview is given of a computer arrangement that can be used to carry out the method according to the invention. The arrangement comprises a processor 1 for carrying out arithmetic operations. In another embodiment, the arrangement can comprise dedicated hardware.

In an embodiment the processing frequency of the processor is at least 400 cycles per output sample. However, the number of cycles is highly dependent on the resampling parameters.

The processor 1 is connected to a plurality of memory components, including a hard disk 5, Read Only Memory (ROM) 7 with at least 400 unit for program and at least 100 unit for data, Electrically Erasable Programmable Read Only Memory (EEPROM) 9, and Random Access Memory (RAM) 11 with at least 100 unit for data. Not all of these types of memory are necessarily provided. Moreover, these memory components need not be located physically close to the processor 1 but may be located remote from the processor 1.

The processor 1 is also connected to interface units for inputting instructions, data etc. by a user, like a keyboard 13, and a mouse 15. Other input units, such as a touch screen, a track ball and/or a voice converter, known to persons skilled in the art may be provided too.

A reading unit 17 connected to the processor 1 is provided. The reading unit 17 is arranged to read data from and possibly write data on a data carrier like a floppy disk 19 or a CDROM 21. Other data carriers may be tapes, DVD, Blue Ray disks, memory sticks, etc. as is known to persons skilled in the art. The data carrier may be provided with a computer program product comprising instructions and data arranged to be read by the processor 1 and, after being read, allowing the processor 1 to perform a method in accordance with the invention. Such a computer program product may then be loaded in one of the memory components 5, 7, 9, 11. However, such computer program product may, alternatively, be downloaded via the telecommunication network 27.

The processor 1 may be connected to a printer 23 for printing output data on paper, as well as to a display 3, for instance, a monitor or LCD (Liquid Crystal Display) screen, a plasma display panel, or any other type of display known to persons skilled in the art.

The processor 1 may be connected to a communication network 27, for instance, the Public Switched Telephone Network (PSTN), a Local Area Network (LAN), a Wide Area Network (WAN), the Internet, etc. by means of an I/O unit 25. The processor 1 may be arranged to communicate with other communication arrangements through the network 27.

The processor 1 may be implemented as standalone system, or as a plurality of parallel operating processors each arranged to carry out subtasks of a larger computer program, or as one or more main processors with several sub-processors. Parts of the functionality of the invention may even be carried out by remote processors communicating with processor 1 through the network 27.

As shown in the drawings for the purposes of illustration, the invention may be embodied in a resampling system included in the computer arrangement that allows updating the resampling ratio. The result of output samples and a plurality of predefined parameters are stored in the memory component which can be any one or more of said hard disk 5, Read Only Memory (ROM) 7, Electrically Erasable Programmable Read Only Memory (EEPROM) 9, and Random Access Memory (RAM) 11.

By an iterative process of executing instructions integrated in a user interface platform 202 as presented on display 3 by processor 1, wherein a plurality of items may provided and collected via the user interface platform 202. Said items represent relevant parameters such as the upsampling ratio, coefficients for the upsampling filter, the order of the interpolating polynomial, coefficients for computing the polynomial coefficients, the sizes of input and output buffer, coefficients to control the adjustment speed of the resampling ratio, etc. The processor 1 allows the user to select one of the items shown on display 3 and predefine the value of said items. The iterative process is activated when a user presses a "initiate" button provided by the user interface platform 202. This iterative process can be steered by the user effectively by allowing him to choose the most interesting parameters to follow, and to choose appropriate criteria for viewing the results. The iterative process is terminated when a user presses a "stop" button provided by the user interface platform 202.

This is only intend to show how an implementation of the invention may work. The skilled reader will understand that many other implementations can be made without departing from the scope of the present invention.

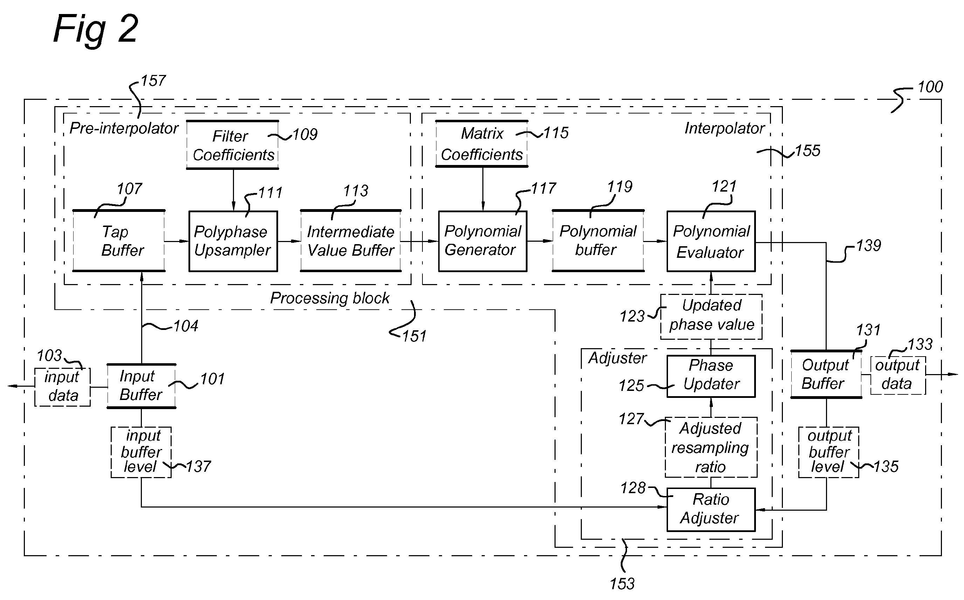

Figure 2 is a schematic structure illustrating a resampler 100 for detecting and adjusting a resample ratio. Figure 2 provides a brief overview of the method of the invention. All actions shown and discussed below will be explained in more details with reference to the other figures.

The resampler 100 depicted in figure 2 has a terminal for receiving input data. The terminal is connected to an input buffer 101 arranged to temporally store the input data 103 based on a 'first-in, first-out' principle. The resampler 100 further comprises an output buffer 131 arranged to temporally store output data 139 based on the 'first-in, first-out' principle. The resampler 100 further comprises a processing block 151 connected to the respective input and output buffers 101,131 and arranged to receive the input data 104 as provided by the input buffer 101 and to generate the output data 139 to the output buffer 131.

The input buffer 101 generates a parameter input buffer level 137. This parameter input buffer level 137 is arranged to indicate the used spaces of the input buffer 101. The output buffer 131 generates a parameter output buffer level 135. This parameter output buffer level 135 is arranged to indicate the used spaces of the output buffer 131. The unused spaces of the output buffer 131 is equal to the size of output buffer 131 minus the used spaces of the output buffer 131. The processing block 151 receives the parameter input buffer level 137 from the input buffer 101 and the parameter output buffer level 135 from the output buffer 131.

The processing block 151 comprises an interpolator 155 arranged to interpolate data and transfer the output data 139 to the output buffer 131, a pre-interpolator 157 arranged to generate pre-interpolated data and deliver the pre-interpolated data to said interpolator 155, and an adjuster 153 arranged to adjust resampling ratio.
- The pre-interpolator 157 comprises a tap buffer 107 arranged to temporally store input data 104 derived from the input buffer 101, a polyphase upsampler 111 arranged to generate pre-interpolated data to said interpolator 155, a filter coefficients table 109 arranged to provide necessary parameters to the polyphase upsampler 111, and an intermediate value buffer 113 arranged to temporally store the pre-interpolated data derived from the polyphase upsampler 111. Said pre-interpolator 157 is not a compulsory component for said processing block 151. An alternative structure of said pre-interpolator 157 is possible.
- The interpolator 155 comprises a polynomial evaluator 121 arranged to evaluate polynomials and generate the output data 139 to the output buffer 131, a polynomial generator 117 arranged to generate and provide polynomials to the polynomial evaluator 121, a matrix coefficients table 115 arranged to provide necessary coefficients to the polynomial generator 117, and a coefficients buffer 119 arranged to temporally store the polynomials generated by the polynomial generator 117 and deliver the polynomials to the polynomial evaluator 121. An alternative structure of said interpolator 155 is possible.
- The adjuster 153 comprises a phase updater 125 arranged to update a phase value 123, and a ratio adjuster 129 arranged to adjust the resampling ratio and transfer an adjusted resampling ratio 127 to the phase updater 125. The adjuster 153 and in particular the ratio adjuster 129 is connected to the input and output buffer 101, 131 for receiving the respective parameter input buffer level, parameter output buffer level 137,135. An alternative structure of said adjuster 153 is possible.

In an embodiment the resampler 100 performs the following steps:
- The incoming input data 103 is stored into the input buffer 101.
- The stored input data 104 is sent from the input buffer 101 to the tap buffer 107 and the parameter input buffer level 137 generated by the input buffer 101 is sent to the ratio adjuster 129, in an embodiment simultaneously.
- The tap buffer 107 holds the last N_TAPS (size of the tap buffer) samples of input data 105 retrieved from the input buffer 101 and sends the input data to polyphase upsampler 111.
- The polyphase upsampler 111 receives both the input data from the tap buffer 107 and the coefficients from the filter coefficients table 109, and the polyphase upsampler 111 sends the pre-interpolated data to intermediate value buffer 113, in an embodiment simultaneously.
- The intermediate value buffer 113 sends the last N_ORDER (the order of the polynomial interpolation) pre-interpolated data to the polynomial generator 117.
- The polynomial generator 117 simultaneously receives both the pre-interpolated data from intermediate value buffer 113 and the coefficients from the matrix coefficients table 115.
- The polynomial generator 117 generates and sends the polynomial coefficients to the polynomial coefficients buffer 119.
- The polynomial evaluator 121 receives both the coefficients from the polynomial coefficients buffer 119 and the phase value 123 from the phase updater 125, and the polynomial evaluator 121 generates and sends the output data 139 to the output buffer 131, in an embodiment simultaneously.
- The output buffer 131 sends out the output data 133 based on the 'first-in, first-out' principle and sends the parameter output buffer level 135 to the ratio adjuster 129, in an embodiment simultaneously.
- The ratio adjuster 129 receives both the parameter input buffer level 137 from the input buffer 101 and the parameter output buffer level 135 from the output buffer 131 and said ratio adjuster 129 sends the adjusted resampling ratio 127 to the phase updater 125, simultaneously.
- The phase updater 125 receives the adjusted resampling ratio 127 and sends the updated phase value 123 to the polynomial evaluator 121, in an embodiment simultaneously.
- The described sequence operates continuously until a 'stop' is provided e.g. by pressing the "stop" button provided on the user interface platform.

Alternative sequences of said resampler 100 is possible. In an alternative sequence, the input to the resampler has already been upsampled. In that case the upsampler can be omitted.

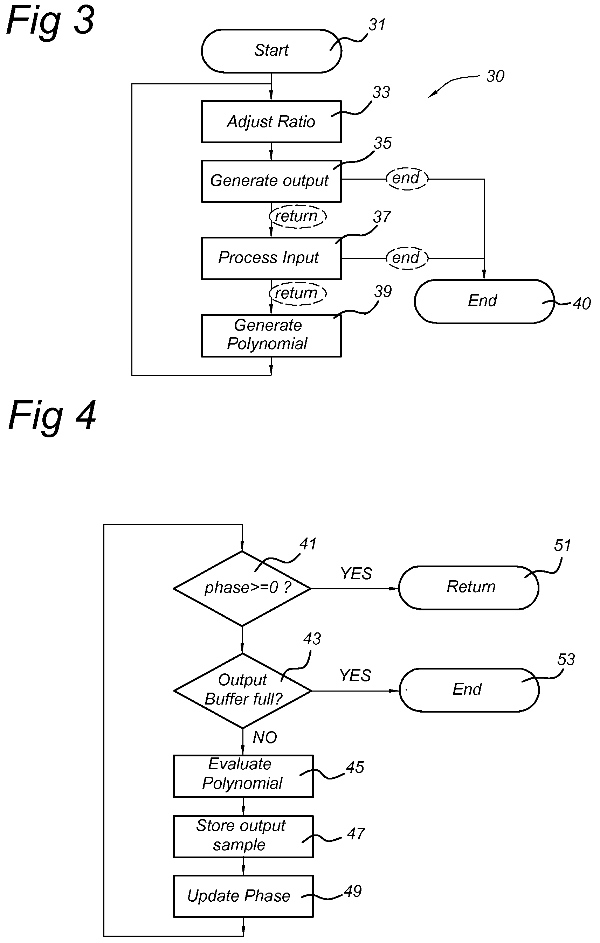

The behaviour of the processing block 151 is further described using the algorithm shown diagrammatically in figure 3:
- In step 31, the processing block 151 starts operating.
- The ratio adjuster 129 starts adjusting the resampling ratio, step 33.
- The processing block 151 starts generating the output data 139, step 35.
- If no more output data is generated, the processing block starts ending, action 40. Otherwise, the processing block starts processing input data, step 37.
- If no more input data is processed, the processing block 151 starts ending, action 40. Otherwise, the processing block 151 starts generating polynomial, step 39.
- The processing block 151 loops back and starts adjusting the resampling ratio, step 33.
- The described actions operates continuously until the "stop" button provided by the user interface platform is pressed.

Figure 4 shows a diagram illustrating an embodiment of an algorithm for sub steps during step 35, 'generate output data':
- In sub-step 41 the processing block 151 checks whether the phase value is no less than zero.
   ∘ If more than zero, then the process is returned, sub-step 51.
- If the phase value is not more than zero , then during step 35 checking is started whether the output buffer 131 is full, sub-step 43.
   ∘ If yes, then step 35 is ended, sub-step 53.
- Otherwise, if the output buffer 131 is not full, evaluation of polynomials is started, sub-step 45.
- In sub-step 47, the output data is stored.
- In sub-step 49, updating of the phase is started.
- Subsequently the algorithm loops back to sub-step 41.

The described actions operates continuously until the "stop" button provided by the user interface platform is pressed.

Alternatives are available for step 35. However the above method steps are advantageous.

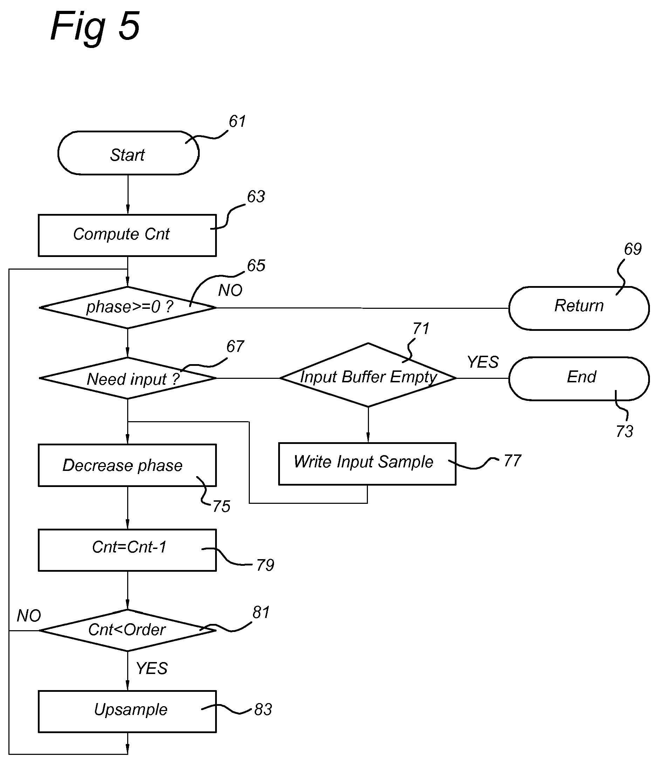

Figure 5 shows a diagram illustrating an embodiment of an algorithm for sub steps during step 37, 'process input':
- In sub-step 61, the process input is started.
- In sub-step 63, a parameter Cnt is calculated.
- In sub-step 65, the processing block checks whether the phase value is no less than zero.
   ∘ If the phase value is not more than zero, then the process is returned, sub-step 69.
- Otherwise, if the phase value is more than zero, a check is started whether input samples data is needed, sub-step 67.
   ∘ If input data is needed, the processing block checks whether the input buffer 103 is empty, sub-step 71.
      ▪ If the input buffer is empty, step 37 is ended, sub-step 73.
      ▪ Otherwise, input data is written to the input buffer 101, sub-step 77.
- If input in sub-step 67 is not needed or when sub step 77 is performed, a decrease of the phase value is performed, sub-step 75.
- Following the decrease of the phase value in sub-step 75, in sub-step 79, the parameter Cnt is decreased by one. Here parameter Cnt is a variable that represents the number of pre-interpolated data samples required to calculate the next output data sample.
- In sub-step 81, because only the last 'order' number pre-interpolated data samples are required to do the polynomial interpolation, the other pre-interpolated data samples are not used, so they do not need to be generated. Therefore, an optimization check is performed whether Cnt is less than the order of the polynomial interpolation.
   ∘ If yes, the step 37 starts upsampling, sub-step 83. Then the process is looped back to sub-step 65.
   ∘ If the Cnt is not less than the order, then the process is directly looped back to sub-step 65.

The described steps operate continuously until the "stop" button provided by the user interface platform is pressed.

Alternatives are available for step 37. For example, if the output sampling rate is known to be lower than the intermediate sampling rate times the order of the polynomial, then the check in sub-step 81 is always true. In that case, the check can be omitted.

The ratio adjuster 129 operates on the used spaces of the input buffer (101) and the output buffer (131), indicated by the respective parameter input buffer level and output buffer level 137,135.

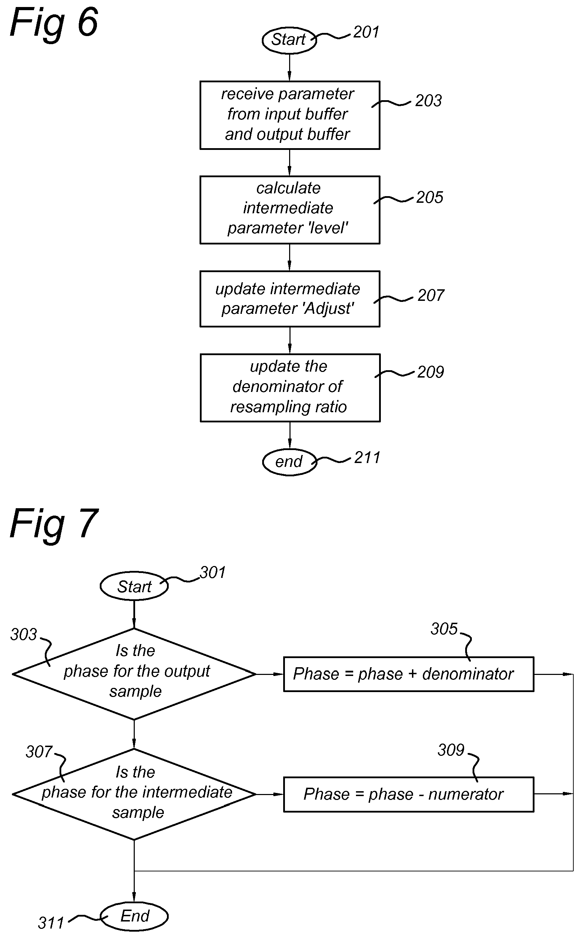

An embodiment of a method performed by the ratio adjuster 129 is described in the data flow diagram depicted in Figure 6:
- In step 201, the ratio adjuster 129 starts operating.
- In step 203, the ratio adjuster 129 starts receiving both the parameter input buffer level 137 from the input buffer 101 and the parameter output buffer level 135 from the output buffer 131.
- In step 205, the ratio adjuster 129 starts calculating an intermediate parameter 'level' by taking into account said parameter input buffer level 137 indicating the used spaces of input buffer 137, and said parameter output buffer level 135 indicating the used spaces of output buffer 135. The size of the output buffer 131 is defined by a parameter output buffer size. The unused spaces of output buffer 135 is equal to the parameter output buffer size subtracted by the parameter output buffer level. Therefore, the calculating formula is given by: Level = (output buffer size - output buffer level)- resampling ratio * input buffer level.
- In step 207, the ratio adjuster 129 starts updating an intermediate parameter 'adjust' by taking into account said intermediate parameter 'level' and coefficients 'alpha' and 'beta' to control the adjustment speed of the resampling ratio; the calculating formula is given by: Adjust = Adjust - alpha * Adjust + beta * Level * abs(Level).
- In step 209, the ratio adjuster 129 starts updating the denominator of resampling ratio by increasing the denominator with the intermediate parameter 'Adjust'.
- The ratio adjuster 129 ends the process, step 211.

The described actions operates continuously until the "stop" button provided by the user interface platform 202 is pressed.

Alternatives are available for performing the method of the ratio adjuster 129. For example, an alternative could be to adjust the ratio with a fixed increment or decrement value, or to omit the factor abs(Level) in step 129.

An embodiment of a method performed by the phase updater 125 is described using the data flow diagram depicted in Figure 7:
- In step 301, the phase updater 125 starts operating.
- In step 303, the phase updater 125 starts checking whether the phase is for the output data.
   ∘ If yes, the phase updater 125 starts updating the phase value by increasing a value that is equal to the denominator of resampling ratio divided by the upsampling factor, step 305. Then the phase updater 125 ends the process, step 311.
   ∘ If the phase is not for the output data, the phase updater starts checking whether the phase is for the pre-interpolated data sample, step 307.
      ▪ If yes, the phase updater 125 starts updating the phase value by decreasing a value that is equal to the numerator of resampling ratio divided by the upsampling factor, step 309. Then the phase updater starts ending, step 311.
- If the phase is neither for the output data nor for the pre-interpolated data, the phase updater ends the operation, step 311.

The described actions operates continuously until the "stop" button provided by the user interface platform is pressed.

Resampling ratio r is continually adjusted by said adjuster 153 based on the parameter 'level':
- If 'level' > 0, the adjuster 153 increases the value of resampling ratio r automatically;
- If 'level' < 0, the adjuster 153 decreases the value of resampling ratio r automatically;
- If |'level' > 0, the adjuster 153 adjust the resampling ratio r quickly in order to prevent buffer underflows / overflows;
- If |'level'| ≈ 0, the adjuster 153 adjust the resampling ratio r slowly in order to achieve low jitter / phase noise.

The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

Although the invention is described using specific embodiments, it will be clear that multiple methods and arrangements are possible within the scope of the invention. The skilled person will be able to combine, adapt, change or leave out one or more of the disclosed specific features of the embodiments.

## Claims

1. A resampling device, comprising an input buffer (101) for storing input data, an output buffer (133) for storing output data, and a processing block (151) for resampling the input data at a resampling ratio to obtain the output data, the processing block (151) being connected to the input buffer (101) and the output buffer (133), the processing block (151) further comprising an interpolator (155) provided with a polynomial evaluator (121), wherein said input buffer (101) is arranged to temporally store a plurality of incoming input data samples and to provide a input buffer fill level (137) and said output buffer (133) is arranged to temporally store a plurality of output data samples and to provide an output buffer fill level (135);
wherein the processing block (151) further comprises an adjuster (153) connected to the interpolator (155), said adjuster (153) being arranged to continuously adjust the resampling ratio on basis of the output buffer fill level (135) and the input buffer fill level (137).

2. Resampling device according to claim 1, wherein said adjuster (153) is connected to the input buffer (101), the output buffer (133), the interpolator (155), and a memory component.

3. Resampling device according to claim 3, that further comprises a phase updater (125), connected to the ratio adjuster (129), and that is arranged to continuously and automatically update a phase value of the output data on basis of the resampling ratio and an upsampling factor received from said ratio adjuster (129).

4. Resampling device according to claim 1-3, wherein said adjuster (153) is connected to a memory component arranged to store a plurality of parameters.

5. Resampling device according to claim 3 or 4, wherein said phase updater (125) is connected to the polynomial evaluator (121) and the memory component, wherein the phase updater (125) is arranged to automatically and continuously update the phase value of the output data in dependency of the resampling ratio: 1) For each output data sample that is generated, the phase is increased by adding a value that is equal to the denominator of said resampling ratio divided by the upsampling factor; 2) For each pre-interpolated data sample that is generated, the phase is decreased by subtracting a value that is equal to the numerator of said resampling ratio divided by the upsampling factor.

6. Resampling device according to claim 3, 4 or 5, wherein the output buffer (133) is connected to the interpolator (155), and wherein said output buffer (133) is arranged to continuously receive the output data samples from said interpolator (155) and store the output data samples.

7. Resampling device according to one of the claims 4 to 6, wherein said polynomial evaluator (121) is arranged to continuously receive the updated phase value from said phase updater (125).

8. Resampling device according to claim 1-7, wherein the device comprises a user interface platform arranged to configure a size of the input buffer (101) and the output buffer (131).

9. Resampling device according to claim 1-8, wherein the ratio adjustor (129) is arranged to automatically and continuously adjust the resampling ratio in accordance with:
the difference between unused memory space in the output buffer and the product of the Resampling ratio and used memory space in the input buffer.

10. Method for resampling comprising:
- buffering input data in an input buffer;
- providing a input buffer level of said input buffer;
- processing the buffered input data for resampling the input data at a resampling ratio to obtain output data, by interpolating the buffered input data using a polynomial evaluator;
- buffering the output data in an output buffer;
- providing an output buffer fill level of said output buffer;
**characterized in that** processing the buffered input data further comprises continuously adjusting the resampling ratio on basis of the output buffer fill level and the input buffer fill level.

11. A computer program, which is stored on a computer readable storage media, and which is suitable to perform the method according to claim 10 when it is run on a digital computer.

## Patentansprüche

1. Neuabtastungsvorrichtung, die einen Eingangspuffer (101) zum Speichern von Eingangsdaten, einen Ausgangspuffer (133) zum Speichern von Ausgangsdaten und einen Verarbeitungsblock (151) zum Neuabtasten der Eingangsdaten mit einem Neuabtastverhältnis für das Erhalten der Ausgangsdaten umfasst, wobei der Verarbeitungsblock (151) mit dem Eingangspuffer (101) und dem Ausgangspuffer (133) verbunden ist, wobei der Verarbeitungsblock (151) weiterhin einen Interpolator (155) umfasst, der mit einem Polynom-Bewerter (121) versehen ist, wobei der Eingangspuffer (101) angeordnet ist, um vorübergehend eine Vielzahl von Eingangsdatenabtastungen zu speichern und einen Eingangspuffer-Füllpegel (137) vorzusehen, und wobei der Ausgangspuffer (133) angeordnet ist, um vorübergehend eine Vielzahl von Ausgangsdatenabtastungen zu speichern und einen Ausgangspuffer-Füllpegel (135) vorzusehen,
wobei der Verarbeitungsblock (151) weiterhin einen Anpasser (153) umfasst, der mit dem Interpolator (155) verbunden ist, wobei der Anpasser (153) angeordnet ist, um kontinuierlich das Abtastverhältnis basierend auf dem Ausgangspuffer-Füllpegel (135) und dem Eingangspuffer-Füllpegel (137) anzupassen.

2. Neuabtastungsvorrichtung nach Anspruch 1 oder 2, wobei der Anpasser (153) mit dem Eingangspuffer (101), dem Ausgangspuffer (133), dem Interpolator (155) und einer Speicherkomponente verbunden ist.

3. Neuabtastungsvorrichtung nach Anspruch 3, die weiterhin einen Phasenaktualisierer (125) umfasst, der mit dem Verhältnisanpasser (129) verbunden ist und angeordnet ist, um kontinuierlich und automatisch einen Phasenwert der Ausgangsdaten basierend auf dem Neuabtastverhältnis und einem von dem Verhältnisanpasser (129) empfangenen Hochabtastfaktor zu aktualisieren.

4. Neuabtastungsvorrichtung nach einem der Ansprüche 1-3, wobei der Anpasser (153) mit einer Speicherkomponente verbunden ist, die angeordnet ist, um eine Vielzahl von Parametern zu speichern.

5. Neuabtastungsvorrichtung nach Anspruch 3 oder 4, wobei der Phasenaktualisierer (125) mit dem Polynom-Bewerter (121) und der Speicherkomponente verbunden ist, wobei der Phasenaktualisierer (125) angeordnet ist, um automatisch und kontinuierlich den Phasenwert der Ausgangsdaten in Abhängigkeit von dem Neuabtastverhältnis zu aktualisieren, wobei 1) für jede erzeugte Ausgangsdatenabtastung die Phase erhöht wird, indem ein Wert gleich dem Nenner des Neuabtastverhältnisses dividiert durch den Hochabtastfaktor addiert wird, und 2) für jede erzeugte vorinterpolierte Datenabtastung die Phase vermindert wird, indem ein Wert gleich dem Nenner des Neuabtastverhältnisses dividiert durch den Hochabtastfaktor subtrahiert wird.

6. Neuabtastungsvorrichtung nach Anspruch 3, 4 oder 5, wobei der Ausgangspuffer (133) mit dem Interpolator (155) verbunden ist und wobei der Ausgangspuffer (133) angeordnet ist, um kontinuierlich die Ausgangsdatenabtastungen von dem Interpolator (155) zu empfangen und die Ausgangsdatenabtastungen zu speichern.

7. Neuabtastungsvorrichtung nach einem der Ansprüche 4 bis 6, wobei der Polynom-Bewerter (121) angeordnet ist, um kontinuierlich den aktualisierten Phasenwert von dem Phasenaktualisierer (125) zu empfangen.

8. Neuabtastungsvorrichtung nach einem der Ansprüche 1 bis 7, wobei das Gerät eine Benutzerschnittstellenplattform umfasst, die angeordnet ist, um eine Größe des Eingangspuffers (101) und des Ausgangspuffers (131) zu konfigurieren.

9. Neuabtastungsvorrichtung nach einem der Ansprüche 1 bis 8, wobei der Verhältnisanpasser (129) angeordnet ist, um automatisch und kontinuierlich das Neuabtastverhältnis in Übereinstimmung mit Folgendem anzupassen:
der Differenz zwischen dem nicht genutzten Speicherraum in dem Ausgangspuffer und dem Produkt aus dem Neuabtastverhältnis und dem genutzten Speicherraum in dem Eingangspuffer.

10. Verfahren zum Neuabtasten, das umfasst:
- Puffern von Eingangsdaten in einem Eingangspuffer,
- Vorsehen eines Eingangspufferpegels des Eingangspuffers,
- Verarbeiten der gepufferten Ein- gangsdaten für eine Neuabtastung der Eingangsdaten mit einem Neuabtastverhältnis, um Ausgangsdaten zu erhalten, durch das Interpolieren der gepufferten Daten unter Verwendung eines Polynom-Bewerters,
- Puffern der Ausgangsdaten in einem Ausgangspuffer,
- Vorsehen eines Ausgangspuffer-Füllpegels des Ausgangspuffers,
**dadurch gekennzeichnet, dass** die Verarbeitung der gepufferten Eingangsdaten weiterhin das kontinuierliche Anpassen des Neuabtastverhältnisses basierend auf dem Ausgangspuffer-Füllpegel und dem Eingangspuffer-Füllpegel umfasst.

11. Computerprogramm, das auf einem computerlesbaren Speichermedium gespeichert ist und geeignet ist, um das Verfahren nach Anspruch 10 durchzuführen, wenn es auf einem digitalen Computer ausgeführt wird.

## Revendications

1. Ré-échantillonneur comprenant une mémoire tampon d'entrée (101) permettant de stocker des données d'entrée, une mémoire tampon de sortie (133) permettant de stocker des données de sortie, et un bloc de traitement (151) permettant de ré-échantillonner les données d'entrée à un taux de ré-échantillonnage pour obtenir les données de sortie, le bloc de traitement (151) étant connecté à la mémoire tampon d'entrée (101) et à la mémoire tampon de sortie (133), le bloc de traitement (151) comprenant en outre un interpolateur (155) muni d'un évaluateur polynomial (121), dans lequel ladite mémoire tampon d'entrée (101) est agencée de manière à stocker temporellement une pluralité d'échantillons de données d'entrée entrants et à indiquer un niveau de remplissage de la mémoire tampon d'entrée (137) et ladite mémoire tampon de sortie (133) est agencée de manière à stocker temporellement une pluralité d'échantillons de données de sortie et à indiquer un niveau de remplissage de la mémoire tampon de sortie (135) ;
dans lequel le bloc de traitement (151) comprend en outre un ajusteur (153) connecté à l'interpolateur (155), ledit ajusteur (153) étant agencé de manière à ajuster, en continu, le taux de ré-échantillonnage en se fondant sur le niveau de remplissage de la mémoire tampon de sortie (135) et le niveau de remplissage de la mémoire tampon d'entrée (137).

2. Ré-échantillonneur selon la revendication 1 ou la revendication 2, dans lequel ledit ajusteur (153) est connecté à la mémoire tampon d'entrée (101), à la mémoire tampon de sortie (133), à l'interpolateur (155), et à un composant de mémoire.

3. Ré-échantillonneur selon la revendication 1, qui comprend en outre un actualisateur de phase (125), connecté à l'ajusteur de taux (129), et qui est agencé de manière à actualiser automatiquement et en continu une valeur de phase des données de sortie en se fondant sur le taux de ré-échantillonnage et un facteur de sur-échantillonnage reçu en provenance dudit ajusteur de taux (129).

4. Ré-échantillonneur selon les revendications 1 à 3, dans lequel ledit ajusteur (153) est connecté à un composant de mémoire agencé pour stocker une pluralité de paramètres.

5. Ré-échantillonneur selon les revendications 3 ou 4, dans lequel ledit actualisateur de phase (125) est connecté à l'évaluateur polynomial (121) et au composant de mémoire, dans lequel l'actualisateur de phase (125) est agencé de manière à mettre à jour automatiquement et en continu la valeur de phase des données de sortie en fonction du taux de ré-échantillonnage : 1) pour chaque échantillon de données de sortie qui est généré, la phase est augmentée en ajoutant une valeur qui est égale au dénominateur dudit taux de ré-échantillonnage divisé par le facteur de sur-échantillonnage ; 2) pour chaque échantillon de données pré-interpolé qui est généré, la phase est diminuée en soustrayant une valeur qui est égale au numérateur dudit taux de ré-échantillonnage divisé par le facteur de sur-échantillonnage.

6. Ré-échantillonneur selon les revendications 3, 4 ou 5, dans lequel la mémoire tampon de sortie (133) est agencée de manière à recevoir en continu les échantillons de données de sortie en provenance dudit interpolateur (155) et à stocker les échantillons de données de sortie.

7. Ré-échantillonneur selon l'une des revendications 4 à 6, dans lequel ledit évaluateur polynomial (121) est agencé de manière à recevoir en continu la valeur de phase actualisée en provenance dudit actualisateur de phase (125).

8. Ré-échantillonneur selon les revendications 1 à 7, dans lequel l'appareil comprend une plateforme d'interface utilisateur agencée de manière à configurer une taille de la mémoire tampon d'entrée (101) et de la mémoire tampon de sortie (131).

9. Ré-échantillonneur selon les revendications 1 à 8, dans lequel l'ajusteur de taux (129) est agencé de manière à ajuster automatiquement et en continu le taux de ré-échantillonnage selon :
la différence entre l'espace de mémoire non utilisé dans la mémoire tampon de sortie et le produit du taux de ré-échantillonnage et de l'espace de mémoire utilisé dans la mémoire tampon d'entrée.

10. Procédé de ré-échantillonnage comprenant :
- la mise en mémoire tampon de données d'entrée dans une mémoire tampon d'entrée ;
- la fourniture d'un niveau de remplissage de mémoire tampon d'entrée de ladite mémoire tampon d'entrée ;
- le traitement des données d'entrées mises en mémoire tampon pour ré-échantillonner les données d'entrée avec un taux de ré-échantillonnage pour obtenir des données de sortie, par interpolation des données d'entrée mises en mémoire tampon en utilisant un évaluateur polynomial ;
- la mise en mémoire tampon des données de sortie dans une mémoire tampon de sortie ;
- la fourniture d'un niveau de remplissage de mémoire tampon de sortie de ladite mémoire tampon de sortie ;
**caractérisé en ce que** le traitement des données d'entrée mises en mémoire tampon comprend en outre le réglage en continu du taux de ré-échantillonnage en se fondant sur le niveau de remplissage de la mémoire tampon de sortie et le niveau de remplissage de la mémoire tampon d'entrée.

11. Programme informatique, qui est stocké sur un support de stockage lisible par un ordinateur, et qui est adapté pour mettre en oeuvre le procédé selon la revendication 10 lorsqu'il est exécuté sur un calculateur numérique.
